# NEUE EUROPÄISCHE PATENTSCHRIFT

(11) **EP 2 396 139 B2**
(45) Veröffentlichungstag und Bekanntmachung des Hinweises auf die Entscheidung über den Einspruch: **02.08.2017**
(45) Hinweis auf die Patenterteilung: 07.05.2014
(21) Anmeldenummer: 10751577.7
(22) Anmeldetag: 03.09.2010
(51) Int. Cl.: B23K 35/02, B23K 35/30, B23K 35/34, B23K 35/36, B23K 35/28, B22F 1/00, B22F 3/10

(54) **METALLPASTE MIT CO-VORLÄUFERN**
METAL PASTE WITH CO-PRECURSORS
PÂTE MÉTALLIQUE À CO-PRÉCURSEURS

(30) Priorität: 04.09.2009 DE 102009040078
(43) Veröffentlichungstag der Anmeldung: 21.12.2011
(73) Patentinhaber: Heraeus Deutschland GmbH & Co. KG, 63450 Hanau (DE)
(72) Erfinder: SCHÄFER, Michael, 36093 Künzell (DE); SCHMITT, Wolfgang, 63110 Rodgau (DE); ZENG, Jian, 59555 Lippstadt (DE)
(74) Vertreter: Heraeus IP
(86) Internationale Anmeldenummer: PCT/EP2010/005400
(87) Internationale Veröffentlichungsnummer: WO 2011/026624

(56) Entgegenhaltungen:
- JP-A- 2008 072 052
- US-A1- 2005 147 917
- US-A1- 2009 134 206
- LU C.-A. ET AL: 'Effects of metallo-organic decomposition agents on thermal decomposition and electrical conductivity of low-temperature-curing silver paste' JAPANESE JOURNAL OF APPLIED PHYSICS Bd. BD. 45, Nr. 9A, 2006, Seiten 6987 - 6992
- SARADA K. ET AL: 'Exploration of the thermal decomposition of oxalates of copper and silver by experimental and computational methods' JOURNAL OF ANALYTICAL AND APPLIED PYROLYSIS Bd. BD. 120, 06 Mai 2016, Seiten 207 - 214

## Beschreibung

Die vorliegende Erfindung betrifft eine Metallpaste und ein Verfahren zum Verbinden von Bauelementen, bei dem diese Metallpaste eingesetzt wird.

Im Bereich der Leistungselektronik stellt das Verbinden von Bauelementen, wie LEDs oder sehr dünnen Siliziumchips, die eine hohe Druck- und Temperaturempfindlichkeit aufweisen, eine besondere Herausforderung dar.

Aus diesem Grund werden solche druck- und temperaturempfindlichen Bauelemente häufig durch Kleben miteinander verbunden. Die Klebetechnik besitzt jedoch den Nachteil, dass damit Kontaktstellen zwischen den Bauelementen geschaffen werden, die nur eine unzureichende Wärmeleitfähigkeit bzw. elektrische Leitfähigkeit aufweisen.

Um dieses Problem zu lösen, werden die zu verbindenden Bauelemente häufig gesintert. Die Sintertechnik stellt ein sehr einfaches Verfahren zum stabilen Verbinden von Bauelementen dar.

Herkömmliche Sinterverfahren benötigen jedoch entweder einen hohen Prozessdruck oder aber eine hohe Prozesstemperatur. Diese Bedingungen führen häufig zu Schädigungen der zu verbindenden Bauelemente, so dass herkömmliche Sinterverfahren für viele Anwendungen ausscheiden.

In der DE 10 2007 046 901 A1 wird eine Sintertechnik vorgeschlagen, mit der es gelingt, sehr gut elektrisch leitende und wärmeleitende Verbindungsschichten für die Leistungselektronik aufzubauen. Bei diesem Sinterverfahren wird eine Metallpaste verwendet, die eine Silberverbindung enthält, die sich unter 300°C zu elementarem Silber zersetzt. Diese Metallpasten ermöglichen eine Verringerung des Prozessdrucks auf unter 3 bar und eine Verringerung der Prozesstemperatur auf unter 250°C. Diese Sintertechnik stellt einen großen Qualitätssprung bei der Verbindung von druck- und temperaturempfindlichen Bauelementen dar.

EP 1 099 507 A1 offenbart eine Metallpaste zum Löten von elektronischen Bauteilen, wobei die Paste Metallpartikel mit einer Beschichtung aus Fettsäuresalzen aufweiset, um ein Oxidieren der Partikel zu verhindern.

JP 2008-72052 offenbart ein Sinterverfahren für elektronische Bauteile, wobei eine Paste mit metallischen Nanopartikeln verwendet wird, und die Partikel mit einer organischen Beschichtung überzogen sind.

Schließlich ist aus EP 1 950 767 A1 eine Silberpaste bekannt, welche mit Fettsäure beschichtete Silberpartikel, sowie Ethylacetat oder Butylacetat als Dispersionsmittel enthält.

Allerdings wäre es für viele Anwendungen wünschenswert, wenn die Prozesstemperatur noch weiter gesenkt werden könnte. Dies würde zu einer geringeren Belastung der zu verbindenden Bauelemente und damit zu einer weiteren Qualitätssteigerung von Bauteilen auf dem Gebiet der Leistungselektronik sorgen. Darüber hinaus könnten bei einer weiteren Senkung der Prozesstemperatur in erheblichem Maße Energiekosten eingespart werden.

Der vorliegenden Erfindung liegt daher die Aufgabe zugrunde, ein Sinterverfahren bereitzustellen, das es erlaubt, Bauelemente auf stabile Weise miteinander zu verbinden, wobei die Prozesstemperatur bei unter 200°C liegt. Dabei sollen Kontaktstellen zwischen den zu verbindenden Bauelementen gebildet werden, die eine niedrige Porosität und eine hohe elektrische und thermische Leitfähigkeit aufweisen.

Eine weitere Aufgabe der vorliegenden Erfindung besteht darin, eine Metallpaste bereitzustellen, die in dem erfindungsgemäßen Sinterverfahren verwendet werden kann, und die eine Erniedrigung der Prozesstemperatur auf unter 200°C und die die Bildung von Kontaktstellen zwischen den zu verbindenden Bauelementen mit niedriger Porosität und hoher elektrischer und thermischer Leitfähigkeit ermöglicht.

Diese Aufgaben werden gelöst durch die Gegenstände der unabhängigen Ansprüche.

Demnach wird ein Verfahren zum Verbinden von Bauelementen zur Verfügung gestellt, bei dem man (a) eine Sandwichanordnung bereitstellt, die wenigstens (a1) ein Bauelement 1, (a2) ein Bauelement 2 und (a3) eine Metallpaste aufweist, die sich zwischen Bauelement 1 und Bauelement 2 befindet, und (b) die Sandwichanordnung sintert, dadurch gekennzeichnet, dass die Metallpaste (A) 75 - 90 Gewichtsprozent wenigstens eines Metalls, das in Form von Partikeln vorliegt, die ein Coating aufweisen, das wenigstens eine organische Verbindung enthält, (B) 0,1 - 12 Gewichtsprozent wenigstens eines Metallprecursors, (C) 6-20 Gewichtsprozent wenigstens eines Lösungsmittels und (D) 0,1 - 15 Gewichtsprozent wenigstens eines Sinterhilfsmittels, das aus der Gruppe ausgewählt ist, bestehend aus (i) Salzen von organischen Säuren, wobei die organischen Säuren 1 - 4 Kohlenstoffatome aufweisen, (ii) Estern von organischen Säuren, wobei die organischen Säuren 1-4 Kohlenstoffatome aufweisen, und (iii) Carbonylkomplexen, umfasst.

Ferner wird eine Metallpaste zur Verfügung gestellt, die (A) 75 - 90 Gewichtsprozent wenigstens eines Metalls, das in Form von Partikeln vorliegt, die ein Coating aufweisen, das wenigstens eine organische Verbindung enthält, (B) 0,1 - 12 Gewichtsprozent wenigstens eines Metallprecursors, (C) 6-20 Gewichtsprozent wenigstens eines Lösungsmittels und (D) 0,1 - 15 Gewichtsprozent wenigstens eines Sinterhilfsmittels, das aus der Gruppe ausgewählt ist, bestehend aus (i) Salzen von organischen Säuren, wobei die organischen Säuren 1 - 4 Kohlenstoffatome aufweisen, (ii) Estern von organischen Säuren, wobei die organischen Säuren 1-4 Kohlenstoffatome aufweisen, und (iii) Carbonylkomplexen, enthält.

Die nachstehenden Erläuterungen sollen die Erfindung nicht einschränken, sondern bieten nur eine mögliche Erklärung für die Wirkungsweise der Erfindung.

Die vorliegende Erfindung beruht einerseits auf der Erkenntnis, dass es für das Sintern von Bauelementen unter Verwendung von Metallpasten vorteilhaft ist, wenn die in der Metallpaste enthaltenen Partikel, vorzugsweise mit Fettsäuren, gecoatet sind. Sind die Metallpartikel nicht gecoatet, dann kommt es zu einer Agglomeration der Metallpartikel in der Metallpaste und zu einer Verklumpung der Metallpartikel in einem frühen Stadium während des Sinterprozesses. Dies hat oft inhomogene Kontaktstellen zwischen den zu verbindenden Bauelementen zur Folge.

Überraschenderweise wurde herausgefunden, dass derart gecoatete Metallpartikel allerdings auch ursächlich dafür sind, dass die Sintertemperatur nicht auf unter 200°C gesenkt werden kann. Solange sich die Coatingverbindungen auf der Oberfläche der Metallpartikel befinden, wird zwar einerseits eine Agglomeration der Metallpartikel verhindert. Andererseits stehen aber auch die Oberflächen der Metallpartikel nicht für den Sintervorgang zur Verfügung, so dass die Metallpartikel nicht gesintert werden können.

Ferner wurde ebenfalls überraschenderweise gefunden, dass die unter der Coatingschicht liegende Oberfläche der Metallpartikel zumeist wenigstens zu einem Teil oxidiert ist. Solche Metalloxidschichten beeinträchtigen die für das Sintern erforderlichen Diffusionsprozesse und haben somit eine Verlangsamung der Diffusionsgeschwindigkeit zur Folge. Auch aus diesem Grund ist es beim Sintern mittels dieser an der Oberfläche oxidierten Metallpartikel nötig, hohe Prozesstemperaturen von weit über 200°C zu verwenden.

Erfindungsgemäß werden Sinterhilfsmittel eingesetzt, die während dem Sinterprozess Kohlenmonoxid freisetzen bzw. bei deren Verbrennung Kohlenmonoxid entsteht. Das während dem Sintern freigesetzte Kohlenmonoxid ist ein Reduktionsmittel und als solches in der Lage, das auf der Oberfläche der Metallpartikel vorhandene Metalloxid zu reduzieren. Die Entfernung des Metalloxids gewährleistet eine behinderungsfreie Diffusion und damit einhergehend eine Steigerung der Diffusionsgeschwindigkeit. Bei dieser Reduktion des Metalloxids wird außerdem in situ reaktives Metall erzeugt, das den Sinterprozess weiter begünstigt. Ferner kann dieses reaktive Metall während des Sinterprozesses zwischen den Metallatomen der Metallpartikel vorhandene Lücken auffüllen und so die Porosität der Kontaktstelle zwischen den zu verbindenden Bauelementen signifikant erniedrigen. Dadurch werden äußerst stabile und wärmeleitfähige sowie elektrisch leitfähige Kontaktstellen erzeugt.

Aus einem bisher noch nicht bekannten Grund scheinen die erfindungsgemäß eingesetzten Sinterhilfsmittel auch das Abbrennen der auf den Silberpartikeln enthaltenen Coatingverbindungen bei Temperaturen unterhalb von 200°C zu begünstigen. Somit stehen bereits bei Temperaturen von unter 200°C die Oberflächen der Metallpartikel für den Sinterprozess zur Verfügung.

Durch den Einsatz der erfindungsgemäßen Sinterhilfsmittel kann somit die Prozesstemperatur beim Sintern signifikant reduziert werden. Überraschend ist dabei, dass es trotz des Abbrennens der Coatingverbindungen bei Temperaturen von unter 200°C nicht zu einer Agglomeration der Metallpartikel kommt, sondern homogene und stabile Kontaktstellen zwischen den zu verbindenden Bauelementen entstehen.

Die vorstehend beschriebenen Effekte scheinen im Ergebnis dazu zu führen, dass es bei Verwendung der eingesetzten Sinterhilfsmittel gelingt, die Sintertemperatur auf unter 200°C zu erniedrigen und trotzdem stabile und wärmeleitfähige sowie elektrisch leitfähige Kontaktstellen zwischen den durch den Sinterprozess zu verbindenden Bauelementen zu erzeugen.

Der Einsatz von Metallpasten in einem Sinterprozess zum Verbinden von Bauelementen im Bereich der Leistungselektronik ist bekannt.

Erfindungsgemäß enthält die Metallpaste wenigstens ein Metall.

Unter den Begriff Metall fallen vorliegend sowohl reine Metalle als auch Metalllegierungen.

Im Rahmen der Erfindung bezieht sich der Begriff Metall auf ein Element, das im Periodensystem der Elemente in der selben Periode wie Bor, aber links von Bor, in der selben Periode wie Silicium, aber links von Silicium, in der selben Periode wie Germanium, aber links von Germanium, und in der selben Periode wie Antimon, aber links von Antimon steht, sowie auf alle Elemente, die eine höhere Ordnungszahl als 55 aufweisen.

Als reine Metalle werden erfindungsgemäß Metalle verstanden, die ein Metall mit einer Reinheit von wenigstens 95 Gewichtsprozent, bevorzugt wenigstens 98 Gewichtsprozent, mehr bevorzugt wenigstens 99 Gewichtsprozent und noch mehr bevorzugt wenigstens 99,9 Gewichtsprozent enthalten.

Gemäß einer bevorzugten Ausführungsform handelt es sich bei dem Metall um Kupfer, Silber, Gold, Nickel, Palladium, Platin oder Aluminium.

Als Metalllegierungen werden erfindungsgemäß metallische Gemische aus wenigstens zwei Komponenten verstanden, von denen wenigstens eine ein Metall ist.

Gemäß einer bevorzugten Ausführungsform wird erfindungsgemäß als Metalllegierung eine Legierung eingesetzt, die Kupfer, Aluminium, Nickel und/oder Edelmetalle enthält. Die Metalllegierung umfasst vorzugsweise wenigstens ein Metall, das aus der Gruppe ausgewählt ist, die aus Kupfer, Silber, Gold, Nickel, Palladium, Platin und Aluminium besteht. Besonders bevorzugte Metalllegierungen enthalten wenigstens zwei Metalle, die aus der Gruppe ausgewählt sind, die aus Kupfer, Silber, Gold, Nickel, Palladium, Platin und Aluminium besteht. Es kann ferner bevorzugt sein, dass der Anteil der Metalle, die aus der Gruppe ausgewählt sind, die aus Kupfer, Silber, Gold, Nickel, Palladium, Platin und Aluminium besteht, an der Metalllegierung wenigstens 90 Gewichtsprozent, vorzugsweise wenigstens 95 Gewichtsprozent, mehr bevorzugt wenigstens 99 Gewichtsprozent und noch mehr bevorzugt 100 Gewichtsprozent beträgt. Bei der Legierung kann es sich beispielsweise um eine Legierung handeln, die Kupfer und Silber, Kupfer, Silber und Gold, Kupfer und Gold, Silber und Gold, Silber und Palladium, Platin und Palladium oder Nickel und Palladium enthält.

In der erfindungsgemäßen Metallpaste können als Metall ein reines Metall, mehrere Arten von reinen Metallen, eine Art von Metalllegierung, mehrere Arten von Metalllegierungen oder Mischungen davon enthalten sein.

Das Metall liegt in der Metallpaste in Form von Partikeln vor.

Die Metallpartikel können von unterschiedlicher Gestalt sein. Beispielsweise können die Metallpartikel in der Form von Flakes oder einer sphärischen (kugeligen) Form vorliegen. Gemäß einer besonders bevorzugten Ausführungsform weisen die Metallpartikel die Form von Flakes auf. Dies schließt jedoch nicht aus, dass von den eingesetzten Metallpartikeln auch ein untergeordneter Anteil eine andere Form aufweisen kann. Es ist jedoch bevorzugt, dass wenigstens 70 Gewichtsprozent, mehr bevorzugt wenigstens 80 Gewichtsprozent, noch mehr bevorzugt wenigstens 90 Gewichtsprozent oder 100 Gewichtsprozent der Partikel in der Form von Flakes vorliegen.

Erfindungsgemäß sind die Metallpartikel gecoatet.

Unter einem Coating von Partikeln wird erfindungsgemäß eine festhaftende Schicht auf der Oberfläche von Partikeln verstanden.

Erfindungsgemäß enthält das Coating der Metallpartikel wenigstens eine Art von Coatingverbindungen.

Bei diesen Coatingverbindungen handelt es sich um organische Verbindungen.

Erfindungsgemäß handelt es sich bei den organischen Verbindungen, die als Coatingverbindungen dienen, um kohlenstoffhaltige Verbindungen, die eine Agglomeration der Metallpartikel verhindern.

Gemäß einer bevorzugten Ausführungsform tragen die als Coatingverbindungen wenigstens eine funktionelle Gruppe. Als funktionelle Gruppen kommen insbesondere Carbonsäuregruppen, Carboxylatgruppen, Estergruppen, Ketogruppen, Aldehydgruppen, Aminogruppen, Amidgruppen, Azogruppen, Imidgruppen, Cyanogruppen oder Nitrilgruppen in Betracht. Bevorzugte funktionelle Gruppen sind Carbonsäuregruppen und Estergruppen. Die Carbonsäuregruppe kann deprotoniert sein.

Bei den Coatingverbindungen mit wenigstens einer funktionellen Gruppe handelt es sich vorzugsweise um gesättigte, einfach ungesättigte oder mehrfach ungesättigte organische Verbindungen.

Diese Coatingverbindungen mit wenigstens einer funktionellen Gruppe können ferner verzweigt oder unverzweigt sein.

Die erfindungsgemäßen Coatingverbindungen mit wenigstens einer funktionellen Gruppe weisen vorzugsweise 1 - 50, mehr bevorzugt 2 - 24, noch mehr bevorzugt 6-24 und noch mehr bevorzugt 8-20 Kohlenstoffatome auf.

Die Coatingverbindungen können ionisch oder nichtionisch sein.

Vorzugsweise kommen als Coatingverbindungen freie Fettsäuren, Fettsäuresalze oder Fettsäureester zum Einsatz.

Die freien Fettsäuren, Fettsäuresalze und Fettsäureester sind vorzugsweise unverzweigt.

Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Kupfer, Aluminium, Lithium, Natrium und Kalium.

Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 - 24, mehr bevorzugt 10-24 und noch mehr bevorzugt 12-18 Kohlenstoffatomen.

Bevorzugte Coatingverbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) sowie die entsprechenden Ester und Salze.

Besonders bevorzugte Coatingverbindungen sind Dodecansäure, Octadecansäure, Kupferstearat, Aluminiumstearat, Natriumstearat, Kaliumstearat, Natriumpalmitat und Kaliumpalmitat.

Die erfindungsgemäß verwendeten Coatingverbindungen werden mittels herkömmlicher und aus dem Stand der Technik bekannter Verfahren auf die Oberfläche der Metallpartikel aufgetragen.

Beispielsweise ist es möglich, die Coatingverbindungen, insbesondere die vorstehend erwähnten Stearate oder Palmitate, in Lösungsmitteln aufzuschlämmen und die aufgeschlämmten Coatingverbindungen in Kugelmühlen mit den Metallpartikeln zu vermahlen. Nach dem Mahlen werden die nun mit den Coatingverbindungen beschichteten Metallpartikel getrocknet und anschließend entstaubt.

Vorzugsweise beträgt der Anteil an organischen Verbindungen, insbesondere der Anteil an Verbindungen, die aus der Gruppe ausgewählt sind, die aus freien Fettsäuren, Fettsäuresalzen und Fettsäureestern besteht, die vorzugsweise 8 - 24, mehr bevorzugt 10 - 24 und noch mehr bevorzugt 12-18 Kohlenstoffatome aufweisen, an dem gesamten Coating wenigstens 60 Gewichtsprozent, mehr bevorzugt wenigstens 70 Gewichtsprozent, noch mehr bevorzugt wenigstens 80 Gewichtsprozent, noch mehr bevorzugt wenigstens 90 Gewichtsprozent, insbesondere wenigstens 95 Gewichtsprozent, wenigstens 99 Gewichtsprozent oder 100 Gewichtsprozent.

Üblicherweise beträgt der Anteil der Coatingverbindungen, vorzugsweise der Coatingverbindungen, die aus der Gruppe ausgewählt sind, die aus freien Fettsäuren, Fettsäuresalzen und Fettsäureestern mit 8 - 24, mehr bevorzugt 10-24 und noch mehr bevorzugt 12-18 Kohlenstoffatomen besteht, 0,01 - 2 Gewichtsprozent, vorzugsweise 0,3 - 1,5 Gewichtsprozent, mehr bevorzugt 0,4 - 1,4 Gewichts-prozent und noch mehr bevorzugt 0,5 - 1,0 Gewichtsprozent, bezogen auf das Gewicht der gecoateten Metallpartikel.

Der Coatinggrad, der als Verhältnis der Masse an Coatingverbindungen zur Oberfläche der Metallpartikel definiert ist, beträgt vorzugsweise 0,00005 - 0,03 g, mehr bevorzugt 0,0001 - 0,02 g und noch mehr bevorzugt 0,0005 - 0,02 g an Coatingverbindungen pro Quadratmeter (m²) Oberfläche der Metallpartikel.

Die erfindungsgemäße Metallpaste umfasst neben den gecoateten Metallpartikeln wenigstens einen Metallprecursor.

Unter Metallprecursor wird im Rahmen der Erfindung eine Verbindung verstanden, die wenigstens ein Metall enthält. Vorzugsweise handelt es sich dabei um eine Verbindung, die sich bei Temperaturen von unter 200°C unter Freisetzung eines Metalls zersetzt. Vorzugsweise wird demnach bei Verwendung eines Metallprecursors beim Sinterprozess in situ ein Metall gebildet. Es kann auf einfache Weise ermittelt werden, ob es sich bei einer Verbindung um einen Metallprecursor gemäß dieser bevorzugten Ausführungsform handelt. So kann beispielsweise eine Paste, die eine zu testende Verbindung enthält, auf ein Substrat mit einer Silberoberfläche abgeschieden, auf 200°C erhitzt und bei dieser Temperatur für 20 Minuten belassen werden. Danach wird überprüft, ob sich unter diesen Bedingungen die zu testende Verbindung zu einem Metall zersetzt hat. Hierzu kann beispielsweise vor dem Test der Gehalt der metallhaltigen Pastenbestandteile ausgewogen und daraus die theoretische Masse des Metalls berechnet werden. Nach dem Test wird die Masse des auf dem Substrat abgeschiedenen Materials gravimetrisch bestimmt. Entspricht die Masse des auf dem Substrat abgeschiedenen Materials der theoretischen Masse des Metalls, wobei die üblichen Messabweichungen zu berücksichtigen sind, handelt es sich bei der getesteten Verbindung um einen Metallprecursor gemäß dieser bevorzugten Ausführungsform.
Gemäß einer bevorzugten Ausführungsform handelt es sich bei dem Metallprecursor um einen endotherm zersetzbaren Metallprecursor. Erfindungsgemäß soll unter endotherm zersetzbarem Metallprecursor ein Metallprecursor verstanden werden, dessen thermische Zersetzung, vorzugsweise unter Schutzgasatmosphäre, einen endothermen Vorgang darstellt. Bei dieser thermischen Zersetzung soll es zur Freisetzung von Metall aus dem Metallprecursor kommen.

Gemäß einer weiteren bevorzugten Ausführungsform weist der Metallprecursor ein Metall auf, das auch im Metallpulver enthalten ist.

Vorzugsweise umfasst der Metallprecursor als Metall wenigstens ein Element, das aus der Gruppe ausgewählt ist, die aus Kupfer, Silber, Gold, Nickel, Palladium und Platin besteht.

Es kann bevorzugt sein, als Metallprecursor endotherm zersetzbare Carbonate, Lactate, Formiate, Citrate, Oxide oder Fettsäuresalze, vorzugsweise Fettsäuresalze mit 6 bis 24 Kohlenstoffatomen, der genannten Metalle zu verwenden.

In besonderen Ausführungsformen werden als Metallprecursor Silbercarbonat, Silberlactat, Silberformiat, Silbercitrat, Silberoxid (zum Beispiel AgO oder Ag₂O), Kupferlactat, Kupferstearat, Kupferoxide (zum Beispiel Cu₂O oder CuO) oder Goldoxide (zum Beispiel Au₂O oder AuO) eingesetzt.

Gemäß einer besonders bevorzugten Ausführungsform wird als Metallprecursor Silbercarbonat, Silber(I)-oxid oder Silber(II)-oxid verwendet.

Falls vorhanden, liegt der Metallprecursor in der Metallpaste vorzugsweise in der Form eines Pulvers vor, das aus Partikeln besteht.

Die Partikel des Pulvers können die Form von Flakes oder eine sphärische (kugelige) Form aufweisen. Vorzugsweise liegen die Partikel des Metallprecursors jedoch als Flakes vor.

Die Verwendung eines Metallprecursors, der während des Sinterprozesses in situ Metall freisetzt, hat zur Folge, dass das in situ gebildete Metall während des Sinterprozesses Lücken zwischen den in der Metallpaste enthaltenen Metallpartikeln schließt. Auf diese Weise kann die Porosität einer Kontaktstelle zwischen zwei zu verbindenden Bauelementen reduziert werden.

Die erfindungsgemäße Metallpaste enthält ferner wenigstens ein Lösungsmittel.

Unter Lösungsmittel werden erfindungsgemäß Verbindungen verstanden, die andere Verbindungen auf physikalischem Wege zur Lösung bringen können. Bei diesen anderen Verbindungen handelt es sich jedoch vorzugsweise nicht um das Metall der Metallpaste.

Erfindungsgemäß kommen als Lösungsmittel die üblicherweise für Metallpasten verwendeten Lösungsmittel in Betracht.

Die erfindungsgemäße Metallpaste enthält ferner wenigstens ein Lösungsmittel.

Unter Lösungsmittel werden erfindungsgemäß Verbindungen verstanden, die andere Verbindungen auf physikalischem Wege zur Lösung bringen können. Bei diesen anderen Verbindungen handelt es sich jedoch vorzugsweise nicht um das Metall der Metallpaste.

Erfindungsgemäß kommen als Lösungsmittel die üblicherweise für Metallpasten verwendeten Lösungsmittel in Betracht.

Vorzugsweise werden als Lösungsmittel organische Verbindungen verwendet, die wenigstens ein Heteroatom tragen und 6-24 Kohlenstoffatome, mehr bevorzugt 8-20 Kohlenstoffatome, aufweisen.

Diese organischen Verbindungen können verzweigt oder unverzweigt sein. Bei den organischen Verbindungen kann es sich auch um zyklische Verbindungen handeln.

Ferner können die als Lösungsmittel verwendeten organischen Verbindungen gesättigte, einfach ungesättigte oder mehrfach ungesättigte Verbindungen sein.

Das wenigstens eine Heteroatom, das in den organischen Verbindungen, die als Lösungsmittel dienen können, enthalten ist, ist vorzugsweise aus der Gruppe ausgewählt, die aus Sauerstoffatomen und Stickstoffatomen besteht.

Das wenigstens eine Heteroatom kann Teil von wenigstens einer funktionellen Gruppe sein. Als funktionelle Gruppen kommen vorzugsweise Hydroxylgruppen, Carbonsäuregruppen, Estergruppen, Ketogruppen, Aldehydgruppen, Aminogruppen, Amidgruppen, Azogruppen, Imidgruppen, Cyanogruppen oder Nitrilgruppen in Betracht.

Gemäß einer besonders bevorzugten Ausführungsform handelt es sich bei dem verwendeten Lösungsmittel um einen Alkohol.

Gemäß einer besonders bevorzugten Ausführungsform werden als Lösungsmittel α-Terpineol ((R)-(+)-α-Terpineol, (S)-(-)-α-Terpineol oder Racemate), β-Terpineol, γ-Terpineol, δ-Terpineol, Mischungen der vorstehend genannten Terpineole, N-Methyl-2-pyrrolidon, Ethylenglycol, Dimethylacetamid, 1-Tridecanol, 2-Tridecanol, 3-Tridecanol, 4-Tridecanol, 5-Tridecanol, 6-Tridecanol, Isotridecanol und Mischungen dieser Isotridecanole, dibasische Ester (vorzugsweise Dimethylester der Glutar-, Adipin- oder Bernsteinsäure oder Mischungen davon), Glycerin, Diethylenglycol, Triethylenglycol oder Mischungen hiervon verwendet.

Vorzugsweise ist das verwendete Lösungsmittel in der Lage, das in der Metallpaste enthaltene Sinterhilfsmittel zu lösen.

Um ein Absenken der Sintertemperatur auf unter 200°C zu ermöglichen, ist in der erfindungsgemäßen Metallpaste wenigstens ein Sinterhilfsmittel enthalten.

Die erfindungsgemäßen Sinterhilfsmittel gewährleisten, dass die auf der Oberfläche der in der Metallpaste enthaltenen Metallpartikel vorhandenen Metalloxide während des Sintervorgangs reduziert werden. Aus diesem Grund werden als Sinterhilfsmittel Verbindungen eingesetzt, die im Laufe des Sinterprozesses ein Reduktionsmittel freisetzen. Bei diesem Reduktionsmittel handelt es sich um Kohlenmonoxid.

Im Rahmen der Erfindung kann das wenigstens eine Sinterhilfsmittel aus der Gruppe ausgewählt sein, die aus (i) Salzen von organischen Säuren, wobei die organischen Säuren 1-4 Kohlenstoffatome aufweisen, (ii) Estern von organischen Säuren, wobei die organischen Säuren 1 - 4 Kohlenstoffatome aufweisen, und (iii) Carbonylkomplexen besteht.

Diese Verbindungen können als Sinterhilfsmittel dienen, indem sie während des Sinterprozesses Kohlenmonoxid freisetzen und so eine Reduktion der Metalloxide, die auf der Oberfläche der in der Metallpaste enthaltenen Metallpartikel enthalten sind, zu dem entsprechenden Metall bei einer Temperatur von unter 200°C ermöglichen.

Erfindungsgemäß können als Sinterhilfsmittel Salze von organischen Säuren mit 1 - 4 Kohlenstoffatomen eingesetzt werden.

Organische Säuren sind im Rahmen der Erfindung organische Verbindungen, die über wenigstens eine Carbonsäuregruppe verfügen. Sie können durch folgende Formel dargestellt werden

R-COOH Formel (I),

wobei R für einen organischen Rest steht.

Dementsprechend sind Salze von organischen Säuren erfindungsgemäß Verbindungen, die wenigstens eine anionische Komponente mit wenigstens einer Einheit enthalten, die eine Carbonsäuregruppe aufweist, in der formal ein Proton abgespalten ist, und die als kationische Komponente eine von Protonen verschiedene Kationenart aufweisen. Folglich lassen sich Salze von organischen Verbindungen durch folgende Formel darstellen

R-COOX Formel (II),

wobei X für irgendeine kationische Komponente steht.

Erfindungsgemäß steht R für einen organischen Rest, der 1-3 Kohlenstoffatome aufweist.

Im Rahmen der Erfindung kann es bevorzugt sein, dass das Salz in der Metallpaste nicht in dissoziierter Form vorliegt. Dementsprechend wird bei einer Ausführungsform der vorliegenden Erfindung, in der als Sinterhilfsmittel ein Salz einer organischen Säure mit 1 - 4 Kohlenstoffatomen eingesetzt wird, als in der erfindungsgemäßen Metallpaste enthaltenes Lösungsmittel vorzugsweise ein aprotisches Lösungsmittel verwendet.

Erfindungsgemäß wird als Sinterhilfsmittel ein Salz von einer organischen Säure eingesetzt, die 1-4 Kohlenstoffatome aufweist.

Gemäß einer bevorzugten Ausführungsform wird ein Salz von einer organischen Säure verwendet, die 1 - 3 Kohlenstoffatome enthält.

Bei der organischen Säure mit 1 - 4 Kohlenstoffatomen kann es sich vorzugsweise um eine Monosäure oder eine Disäure handeln. Die organische Säure kann eine einprotonige Säure oder eine mehrprotonige Säure, insbesondere eine zweiprotonige Säure, sein.

Die organische Säure kann neben der wenigstens einen Carbonsäuregruppe, auch wenigstens eine weitere funktionelle Gruppen aufweisen. Bei dieser funktionellen Gruppe kann es sich beispielsweise um eine weitere Carbonsäuregruppe, Estergruppe, Ketogruppe, Aldehydgruppe, Hydroxylgruppe, Aminogruppe, Amidgruppe, Imidgruppe, Cyanogruppe, Nitrilgruppe oder ein Halogenatom, insbesondere Fluoratom, Chloratom oder Bromatom, handeln.

Die organische Säure kann neben der in der C=O-Gruppe der wenigstens einen Carbonsäureeinheit formal enthaltenen Doppelbindung weitere Doppelbindungen enthalten.

Vorzugsweise werden als Sinterhilfsmittel Salze von einer Säure verwendet, die aus der Gruppe ausgewählt ist, die aus Essigsäure, Kohlensäure, Ameisensäure, Milchsäure und Oxalsäure besteht.

Als kationische Komponente der erfindungsgemäß eingesetzten Salze können vorzugsweise Metall-Kationen eingesetzt werden.

Bei den Metall-Kationen handelt es sich vorzugsweise um Kationen von Metallen, die eine hohe Affinität zu Sauerstoff aufweisen. Es wird angenommen, dass diese Metalle während dem Sinterprozess Sauerstoff binden können und so das Gleichgewicht der Reaktion von mittels Sinterhilfsmittel freigesetztem Kohlenmonoxid mit den auf der Oberfläche der Metallpartikel vorhandenen Metalloxiden zu Kohlendioxid und den Metallen auf die Produktseite verlagern.

Bevorzugte Metall-Kationen sind Magnesium, Aluminium, Kupfer (I), Kupfer (II), Silber (I), Silber (II), Mangan (III), Eisen (II), Eisen (III), Kobalt (II) und Zinn (II).

Gemäß einer besonders bevorzugten Ausführungsform ist das als Sinterhilfsmittel verwendete wenigstens eine Salz einer organischen Säure mit 1 - 4 Kohlenstoffatomen aus der Gruppe ausgewählt, die aus Kupfer(II)-acetat, Eisen(II)-acetat, Zinn(II)-acetat, Eisen(II)-carbonat, Kupfer(II)-carbonat, Magnesiumformiat, Aluminiumformiat, Eisen(II)-formiat, Zinn(II)-formiat, Kupfer(II)-formiat, Silber(II)-formiat, Mangan(III)-formiat, Kupfer(II)-lactat, Silber(I)-lactat, Eisen(II)-oxalat, Eisen(III)-oxalat und Kobalt(II)-oxalat besteht.

Unter die Erfindung fallen allerdings auch Ausführungsformen, bei denen es ausgeschlossen sein kann, dass die Metallpaste als Salz einer organischen Säure mit 1 - 4 Kohlenstoffatomen ein Carbonat, Lactat oder Formiat von Kupfer, Silber, Gold, Nickel, Palladium oder Platin, insbesondere Silbercarbonat, Silberlactat, Silberformiat oder Kupferlactat, enthält.

Erfindungsgemäß kann als Sinterhilfsmittel auch ein Ester einer organischen Säure eingesetzt werden, wobei die organische Säure 1-4 Kohlenstoffatome aufweist.

Bei der organischen Säure mit 1 - 4 Kohlenstoffatomen, von der sich der erfindungsgemäß eingesetzte Ester ableitet, handelt es sich vorzugsweise um eine organische Säure mit 1 - 4 Kohlenstoffatomen, wie sie vorstehend im Zusammenhang mit Salzen von organischen Säuren, die 1-4 Kohlenstoffatome aufweisen, beschrieben wurde.

Folglich handelt es sich bei dem erfindungsgemäß eingesetzten Ester vorzugsweise um einen Monoester oder um einen Mehrfachester, insbesondere einen Diester.

Im Rahmen der Erfindung steht Ester für eine Verbindung, in der wenigstens ein Wasserstoff der wenigstens einen Carbonsäureeinheit der organischen Säure mit 1 - 4 Kohlenstoffatomen formal durch eine organische Gruppe ersetzt ist.

Demnach stellen Ester Verbindungen dar, die sich mit der obigen Formel (II) beschreiben lassen, wobei jedoch der Rest X eine organische Gruppe darstellt.

Werden als Ester von organischen Säuren mit 1 - 4 Kohlenstoffatomen Diester eingesetzt, dann sind formal die Wasserstoffatome von zwei Carbonsäureeinheiten oder die Wasserstoffatome von einer Carbonsäureeinheit einer zweiprotonigen Säure durch organische Gruppen ersetzt. Diese organischen Gruppen können gleichartig oder verschieden sein.

Erfindungsgemäß handelt es sich bei dieser wenigstens einen organischen Gruppe, die in der wenigstens einen Carbonsäureeinheit der organischen Säure mit 1 - 4 Kohlenstoffatomen wenigstens ein Wasserstoffatom formal ersetzt, vorzugsweise um eine Gruppe mit 1-10, mehr bevorzugt 1-7 und noch mehr bevorzugt 1-4 Kohlenstoffatomen.

Diese organische Gruppe kann unverzweigt oder verzweigt sein, ist aber vorzugsweise unverzweigt.

Die organische Gruppe kann ein oder mehrere Heteroatome tragen. Als Heteroatome kommen insbesondere Sauerstoff, Stickstoff und Halogene, wie zum Beispiel Fluor, Chlor, Brom oder Iod, in Betracht. Es kann aber auch bevorzugt sein, dass die organische Gruppe keine Heteroatome trägt.

Sind in der organischen Gruppe Heteroatome vorhanden, dann können diese Teil einer funktionellen Gruppe sein. Beispiele für solche funktionelle Gruppen sind Carbonsäuregruppen, Estergruppen, Ketogruppen, Aldehydgruppen, Aminogruppen, Amidgruppen, Azogruppen, Imidgruppen, Cyanogruppen und Nitrilgruppen.

Die organische Gruppe kann eine aliphatische oder aromatische Gruppe sein. Vorzugsweise handelt es sich bei der organischen Gruppe um eine aliphatische Gruppe.

Gemäß einer besonders bevorzugten Ausführungsform ist die aliphatische Gruppe eine Alkylgruppe. Diese Alkylgruppe weist vorzugsweise 1-10, mehr bevorzugt 1-7 und noch mehr bevorzugt 1 - 4 Kohlenstoffatome auf. Gemäß dieser Ausführungsform ist die Alkylgruppe unverzweigt. Vorzugsweise enthält diese Alkylgruppe keine Heteroatome. Besonders bevorzugte Alkylgruppen sind Methylgruppen, Ethylgruppen, Propylgruppen und Butylgruppen.

Folglich sind die erfindungsgemäß eingesetzten Ester von organischen Säuren, wobei die organischen Säuren 1-4 Kohlenstoffatome aufweisen, vorzugsweise aus der Gruppe ausgewählt, die aus Methylestern, Ethylestern, Propylestern und Butylestern besteht.

Gemäß dieser Ausführungsform handelt es sich bei den erfindungsgemäßen Estern von organischen Säuren mit 1 - 4 Kohlenstoffatomen um Verbindungen, die durch Formel (II) dargestellt werden können, wobei der Rest X für eine Alkylgruppe, vorzugsweise für eine Methylgruppe. Ethylgruppe, Propylgruppe oder Butylgruppe, steht.

Besonders bevorzugte Ester von organischen Säuren mit 1 - 4 Kohlenstoffatomen sind folglich Methylacetat, Ethylacetat, Propylacetat, Butylacetat, Dimethylcarbonat, Diethylcarbonat, Dipropylcarbonat, Dibutylcarbonat, Methylethylcarbonat, Methylpropylcarbonat, Methylbutylcarbonat, Ethylpropylcarbonat, Ethylbutylcarbonat, Methylformiat, Ethylformiat, Propylformiat, Butylformiat, Methyllactat, Ethyllactat, Propyllactat, Butyllactat, Dimethyloxalat, Dieethyloxalat, Dipropyloxalat und Dibutyloxalat.

Als Sinterhilfsmittel können erfindungsgemäß auch Carbonylkomplexe eingesetzt werden.

Der Begriff Carbonylkomplexe beschreibt erfindungsgemäß carbonylgruppenhaltige Metallkomplexe, in denen wenigstens ein CO-Molekül koordinativ an wenigstens ein Metallatom gebunden ist.

Neben dem wenigstens einen CO-Molekül können die Carbonylkomplexe auch noch weitere Liganden aufweisen. Bei diesen weiteren Liganden kann es sich um elementare oder molekulare Liganden handeln.

Die Liganden können einzahnig oder mehrzahnig sein.

Bevorzugte elementare Liganden sind Wasserstoff und Halogene. Als Halogene sind Fluor, Chlor, Brom und Iod bevorzugt.

Bevorzugte molekulare Liganden sind Stickstoffoxide, Cyanide und organische Liganden.

Bei den organischen Liganden handelt es sich vorzugsweise um ionische oder ungesättigte Liganden.

Als organische Liganden kommen organische Liganden mit wenigstens einem Kohlenstoffatom in Betracht. Vorzugsweise handelt es sich bei den organischen Liganden mit wenigstens einem Kohlenstoffatom um organische Liganden mit 2 - 20, mehr bevorzugt 2-16 und noch mehr bevorzugt 2-12 Kohlenstoffatomen.

Die organischen Liganden können verzweigt oder unverzweigt sein.

Die organischen Liganden können ferner gesättigt oder einfach oder mehrfach ungesättigt sein.

Die organischen Liganden können ferner eine Ringstruktur aufweisen. In dieser Ringstruktur kann auch wenigstens ein Heteroatom enthalten sein. Dieses wenigstens eine Heteroatom kann vorzugsweise Stickstoff oder Sauerstoff sein.

Bei den organischen Liganden kann es sich auch um aromatische Liganden handeln.

Als ionische Liganden können Alkylliganden, vorzugsweise unverzweigte Alkylliganden, wie zum Beispiel Methylliganden, oder Cyclopentadienyl bevorzugt sein.

Als ungesättigte organische Liganden können Alkene, konjugierte oder nicht konjugierte Diene und Allyle bevorzugt sein. Erfindungsgemäß sind als organische Gruppen auch π-Allyl und Aromaten-Übergangsmetall-Komplexe vorgesehen.

Die erfindungsgemäß eingesetzten Carbonylkomplexe können ein oder mehrere Metallatome enthalten. Weisen die Carbonylkomplexe mehrere Metallatome auf, dann können diese Metallatome gleichartig oder verschiedenartig sein.

Als Metalle der Carbonylkomplexe werden vorzugsweise Metalle verwendet, die eine hohe Affinität zu Sauerstoff aufweisen.

Vorzugsweise weisen die Carbonylkomplexe wenigstens ein Element der Übergangsmetalle, also Elemente der 3. bis 11. Gruppe des Periodensystems der Elemente, auf.

Erfindungsgemäß kann es ferner bevorzugt sein, dass das wenigstens eine Metall der erfindungsgemäß eingesetzten Metallcarbonyle ein Metall ist, das aus der Gruppe ausgewählt ist, die aus Vanadium, Molybdän, Wolfram, Mangan, Eisen, Ruthenium, Osram, Cobalt, und Nickel besteht.

Gemäß einer bevorzugten Ausführungsform handelt es sich bei den Carbonylkomplexen um Metallcarbonyle.

Der Begriff Metallcarbonyle soll im Rahmen der Erfindung Verbindungen beschreiben, die ein- oder mehrkernige Koordinationsverbindungen darstellen, in denen ausschließlich Kohlenmonoxid-Moleküle koordinativ an Metallatome gebunden sind,

Metallcarbonyle können erfindungsgemäß ein Metallatom oder mehrere Metallatome enthalten.

Die in den Metallcarbonylen enthaltenen Metallatome können gleichartig oder verschiedenartig sein.

Vorzugsweise handelt es sich bei den Metallatomen der Metallcarbonyle um Elemente der Übergangsmetalle, also um Elemente der 3. bis 11. Gruppe des Periodensystems der Elemente.

Gemäß einer bevorzugten Ausführungsform handelt es sich bei dem wenigstens einen Metall der erfindungsgemäß eingesetzten Metallcarbonyle um ein Metall, das aus der Gruppe ausgewählt ist, die aus Vanadium, Molybdän, Wolfram, Mangan, Eisen, Ruthenium, Osram, Cobalt, und Nickel besteht.

Das Metallcarbonyl kann ladungsneutral oder als Salz vorliegen. Bei dem Salz kann es sich um ein ein- oder mehrwertiges Salz handeln.

Gemäß einer besonders bevorzugten Ausführungsform ist der erfindungsgemäß als Sinterhilfsmittel eingesetzte Metallkomplex ein Metallkomplex, der aus der Gruppe ausgewählt ist, die aus Vanadiumhexacarbonyl (V(CO)₆), Molybdänhexacarbonyl (Mo(CO)₆), Wolframhexacarbonyl (W(CO)₆), Dimangandecacarbonyl (Mn₂(CO)₁₀), Methylcyclopentadienylmangantricarbonyl ((CH₃C₅Hq)Mn(CO)₃), Eisenpentacarbonyl (Fe(CO)₅), Dieisennonacarbonyl (Fe₂(CO)₉), Trieisendodecacarbonyl (Fe₃(CO)₁₂), Diprototetracarbonylferrat(II) (H₂[Fe(CO)₄]), Dicarbonyldiiodeisen (Fe(CO)₂I₂), Trikaliumcarbonylpentacyanoferrat (K₃[Fe(CN)₅CO], 1,2-Bis-(hexamethylbenzol)-tetracarbonyldieisen (0) (C₁₂H₁₈Fe(CO)₄FeC₁₂H₁₈), Carbidopentaeisenpentadecacarbonyl (Fe₅C(CO)₁₅, Rutheniumpentacarbonyl (Ru(CO)₅, Dirutheniumnonacarbonyl (Ru₂(CO)₉), Trirutheniumdodecacarbonyl (Ru₃(CO)₁₂, Hexarutheniumhexadecacarbonyl (Ru₆(CO)₁₆), Osrampentacarbonyl (Os(CO)₅), Triosramdodecacarbonyl (Os₃(CO)₁₂), Pentaosramhexadecacarbonyl (Os₅(CO)₁₆), Hexaosramoktadecacarbonyl (Os₆(CO)₁₈), Dicobaltoktacarbonyl (Os₂(CO)₈), Tetracobaltdodecacarbonyl (Os₄(CO)₁₂), Hexacobalthexadecacarbonyl (Co₆(CO)₁₆), Nickeltetracarbonyl (Ni(CO)₄) Dinatriumcarbonylferrat (Na₂[Fe(eO)₄]) besteht.

Die erfindungsgemäßen Sinterhilfsmittel werden vorzugsweise als Bestandteil einer Metallpaste verwendet, die in einem Sinterprozess zum Einsatz kommt. Vorzugsweise werden bei diesem Sinterprozess Bauelemente miteinander verbunden, die in einer Sandwichanordnung über die Metallpaste miteinander in Kontakt stehen.

Die erfindungsgemäß verwendeten Metallpasten können neben Metallen, Metallprecursorn, Lösungsmitteln und Sinterhilfsmitteln auch weitere Inhaltsstoffe aufweisen.

Bei diesen weiteren Inhaltsstoffen kann es sich vorzugsweise um üblicherweise in Metallpasten eingesetzte Inhaltsstoffe handeln.

Beispielsweise können in der Metallpaste als weitere Inhaltsstoffe Dispersionsmittel, Tenside, Entschäumer, Bindemittel, Polymere oder viskositätssteuernde Mittel enthalten sein.

Die erfindungsgemäße Metallpaste enthält 75 - 90 Gewichtsprozent, vorzugsweise 77 - 89 Gewichtsprozent, mehr bevorzugt 78 - 87 Gewichtsprozent und noch mehr bevorzugt 78 - 86 Gewichtsprozent wenigstens eines der hierin beschriebenen, in Form von Partikeln vorliegenden Metalle. Diese Gewichtsangaben schließen das Gewicht der Coatingverbindungen, die auf den Partikeln enthalten sind, mit ein.

Die erfindungsgemäße Metallpaste enthält 0,1 - 12 Gewichtsprozent, mehr bevorzugt 1-10 Gewichtsprozent und noch mehr bevorzugt 2-8 Gewichtsprozent wenigstens eines Metallprecursors.

Die erfindungsgemäße Metallpaste enthält 6-20 Gewichtsprozent, vorzugsweise 7-18 Gewichtsprozent, mehr bevorzugt 8-17 Gewichtsprozent und noch mehr bevorzugt 10-15 Gewichtsprozent wenigstens eines Lösungsmittels.

Die erfindungsgemäße Metallpaste enthält 0,1 - 15 Gewichtsprozent, vorzugsweise 0,1 - 12 Gewichtsprozent, mehr bevorzugt 1-10 Gewichtsprozent und noch mehr bevorzugt 1-8 Gewichtsprozent wenigstens eines der hierin beschriebenen Sinterhilfsmittel.

Die erfindungsgemäße Metallpaste enthält 0-15 Gewichtsprozent, vorzugsweise 0-12 Gewichtsprozent, mehr bevorzugt 0,1-10 Gewichtsprozent und noch mehr bevorzugt 1-10 Gewichtsprozent weitere Inhaltsstoffe.

Folglich enthält die erfindungsgemäße Metallpaste 75 - 90 Gewichtsprozent wenigstens eines der hierin beschriebenen Metalle, 0,1 - 12 Gewichtsprozent wenigstens eines Metallprecursors, 6 - 20 Gewichtsprozent wenigstens eines Lösungsmittels und 0,1-15 Gewichtsprozent wenigstens eines der hierin beschriebenen Sinterhilfsmittel.

Gemäß einer bevorzugten Ausführungsform enthält die erfindungsgemäße Metallpaste 77 - 89 Gewichtsprozent wenigstens eines der hierin beschriebenen Metalle, 0,1 -12 Gewichtsprozent wenigstens eines Metallprecursors, 7-18 Gewichtsprozent wenigstens eines Lösungsmittels und 0,1-12 Gewichtsprozent wenigstens eines der hierin beschriebenen Sinterhilfsmittel.

Gemäß einer mehr bevorzugten Ausführungsform enthält die erfindungsgemäße Metallpaste 78 - 87 Gewichtsprozent wenigstens eines der hierin beschriebenen Metalle, 0,1 - 10 Gewichtsprozent wenigstens eines Metallprecursors, 8-17 Gewichtsprozent wenigstens eines Lösungsmittels und 1-10 Gewichtsprozent wenigstens eines der hierin beschriebenen Sinterhilfsmittel.

Gemäß einer noch mehr bevorzugten Ausführungsform enthält die erfindungsgemäße Metallpaste 78 - 86 Gewichtsprozent wenigstens eines der hierin beschriebenen Metalle, 2-8 Gewichtsprozent wenigstens eines Metallprecursors, 10-15 Gewichtsprozent wenigstens eines Lösungsmittels und 1-8 Gewichtsprozent wenigstens eines der hierin beschriebenen Sinterhilfsmittel.

Gemäß einer besonders bevorzugten Ausführungsform liegt das molare Verhältnis von Sinterhilfsmitteln zu den im Coating der Metallpartikel enthaltenen organischen Verbindungen (Coatingverbindungen) im Bereich von 1 : 1 bis 150 : 1, mehr bevorzugt im Bereich von 3 : 1 bis 100 : 1, noch mehr bevorzugt im Bereich von 5 : 1 bis 80 : 1 und insbesondere im Bereich von 10 : 1 bis 80 : 1. Unter molarem Verhältnis von Sinterhilfsmitteln zu Coatingverbindungen wird erfindungsgemäß der Quotient aus (i) der Summe der Stoffmengen der in der Metallpaste enthaltenen Sinterhilfsmittel und (ii) der Summe der Stoffmengen der im Coating der Metallpartikel enthaltenen Coatingverbindungen bezeichnet. Enthält eine Metallpaste bspw. als Sinterhilfsmittel 0,025 mol Aluminiumformiat und 0,015 mol Kupferformiat und als einzige Coatingverbindung 0,0008 mol Kaliumstearat, so beträgt das molare Verhältnis von Sinterhilfsmitteln zu Coatingverbindungen 50 : 1.

Ein Verhältnis von Sinterhilfsmitteln zu Coatingverbindungen im erfindungsgemäß bevorzugten Bereich hat weitere vorteilhafte Effekte zur Folge. So wird dadurch einerseits gewährleistet, dass während des Sinterprozesses als Resultat des Verbrennens der Coatingverbindungen genügend Kohlenmonoxid zur Reduktion der Metalloxide zur Verfügung steht. Andererseits ist die Menge an Sinterhilfsmitteln dann noch nicht so hoch, dass hierdurch der Sinterprozess beeinträchtigt würde.Wie vorstehend erläutert, kann es erfindungsgemäß bevorzugt sein, wenn es sich bei den im Coating der Metallpartikel enthaltenen organischen Verbindungen um freie Fettsäuren, Fettsäuresalze oder Fettsäureester handelt, die vorzugsweise 8 - 24, mehr bevorzugt 10-24 und noch mehr bevorzugt 12-18 Kohlenstoffatome aufweisen.

Sind in der Metallpaste freie Fettsäuren, Fettsäuresalze oder Fettsäureester mit vorzugsweise 8 - 24, mehr bevorzugt 10-24 und noch mehr bevorzugt 12-18 Kohlenstoffatomen nicht nur als Coatingverbindungen, sondern auch als weitere Inhaltsstoffe in der Metallpaste enthalten, dann kann es bevorzugt sein, dass für die Bestimmung des molaren Verhältnisses von Sinterhilfsmitteln zu Coatingverbindungen der Begriff Coatingverbindungen neben den auf der Oberfläche der Metallpartikel enthaltenen Fettsäuren, Fettsäuresalze oder Fettsäureester auch die Fettsäuren, Fettsäuresalze oder Fettsäureester, die als weitere Inhaltsstoffe in der Metallpaste enthalten sind, umfasst.

Soweit Verbindungen erfindungsgemäß sowohl Sinterhilfsmittel als auch Metallprecursor darstellen, so werden für die Bestimmung der Gewichtsprozente und des molaren Verhältnisses von Sinterhilfsmitteln zu Coatingverbindungen diese Verbindungen vorzugsweise als Sinterhilfsmittel betrachtet.

Vorzugsweise handelt es sich jedoch bei den Sinterhilfsmitteln und den Metallprecursorn um voneinander verschiedene Verbindungen.

Die hierin beschriebenen Metallpasten werden erfindungsgemäß in einem Sinterverfahren eingesetzt.

Unter Sintern wird vorzugsweise das Verbinden von zwei oder mehr Bauelementen durch Erhitzen unter Umgehung der flüssigen Phase verstanden.
Erfindungsgemäß wird unter dem Verbinden von wenigstens zwei Bauelementen das Befestigen von einem ersten Bauelement auf einem zweiten Bauelement verstanden. In diesem Zusammenhang bedeutet "auf" lediglich, dass eine Oberfläche des ersten Bauelements mit einer Oberfläche des zweiten Bauelements verbunden ist, wobei es auf die relative Lage der beiden Bauelemente oder der Anordnung, die die wenigstens zwei Bauelemente enthält, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Teile bezeichnet, die in der Hochleistungselektronik verwendet werden.

Demgemäß kann es sich bei den Bauelementen beispielsweise um Dioden, LEDs (light emitting diodes, lichtemittierende Dioden), DCB (direct copper bonded)-Substrate, Leadframes, Dies, IGBTs (insulated-gate bipolar transistors, Bipolartransistoren mit isolierter Gate-Elektrode), ICs (integrated circuits, integrierte Schaltungen), Sensoren, Kühlkörper (vorzugsweise AluminiumKühlkörper oder Kupfer-Kühlkörper) oder andere passive Baulemente (zum Beispiel Widerstände, Kondensatoren oder Spulen) handeln. Vorzugsweise kann es sich bei den Bauelementen auch um nichtmetallische Bauelemente handeln.

Die zu verbindenden Bauelementen können gleichartige oder verschiedenartige Bauelemente sein.

Unter bevorzugten Ausführungsformen betrifft die Erfindung die Verbindung von LED mit Leadframe, von LED mit keramischem Substrat, von Dies, Dioden, IGBTs oder ICs mit Leadframes, keramischen Substraten oder DCB-Substraten, von Sensor mit Leadframe oder keramischem Substrat, von DCB oder keramischem Substrat mit Kupfer- oder Aluminiumkühlkörper, von Leadframe mit Kühlkörper oder von Tantalkondensatoren, vorzugsweise in ungehäustem Zustand, mit Leadframe.

Ebenfalls bevorzugt können mehr als zwei Bauelemente miteinander verbunden werden. Beispielsweise können (i) LED oder Chip mit (ii) Leadframe und (iii) Kühlkörper verbunden werden, wobei sich der Leadframe vorzugsweise zwischen (i) LED oder Chip und (iii) Kühlkörper befindet. Ebenso kann eine Diode mit zwei Kühlkörpern verbunden werden, wobei sich die Diode vorzugsweise zwischen zwei Kühlkörpern befindet.

Gemäß einer bevorzugten Ausführungsform können die Bauelemente wenigstens eine Metallisierungsschicht umfassen. Diese Metallisierungsschicht ist vorzugsweise Teil des Bauelements. Die Metallisierungsschicht befindet sich vorzugsweise an wenigstens einer Oberfläche des Bauelements.

Die Metallisierungsschicht kann reines Metall aufweisen. So kann es bevorzugt sein, wenn die Metallisierungsschicht wenigstens 50 Gewichtsprozent, mehr bevorzugt wenigstens 70 Gewichtsprozent, noch mehr bevorzugt wenigstens 90 Gewichtsprozent oder aber 100 Gewichtsprozent an reinem Metall aufweist. Das reine Metall ist vorzugsweise aus der Gruppe ausgewählt, die aus Kupfer, Silber, Gold, Palladium und Platin besteht.

Andererseits kann die Metallisierungsschicht auch eine Legierung aufweisen. Die Legierung der Metallisierungsschicht enthält vorzugsweise wenigstens ein Metall, das aus der Gruppe ausgewählt ist, die aus Silber, Gold, Nickel, Palladium und Platin besteht. Es kann auch bevorzugt sein, dass wenigstens zwei Metalle, die aus der Gruppe ausgewählt sind, die aus Silber, Gold, Nickel, Palladium und Platin besteht, in der Legierung der Metallisierungsschicht enthalten sind. Der Anteil der Elemente, die aus der Gruppe ausgewählt sind, die aus Silber, Gold, Nickel, Palladium und Platin besteht, an der Legierung beträgt vorzugsweise wenigstens 90 Gewichtsprozent, mehr bevorzugt wenigstens 95 Gewichtsprozent, noch mehr bevorzugt wenigstens 99 Gewichtsprozent, so zum Beispiel 100 Gewichtsprozent.

Gemäß einer bevorzugten Ausführungsform enthält die Metallisierungsschicht vorzugsweise wenigstens 95 Gewichtsprozent, mehr bevorzugt wenigstens 99 Gewichtsprozent und noch mehr bevorzugt 100 Gewichtsprozent dieser Legierung.

Die Metallisierungsschicht kann auch einen mehrlagigen Aufbau aufweisen. So kann es beispielsweise bevorzugt sein, wenn wenigstens eine Oberfläche der zusammenzufügenden Bauelemente eine Metallisierungsschicht aus mehreren Lagen umfasst, die die vorstehend genannten reinen Metalle und/oder Legierungen aufweisen.

Gemäß einer bevorzugten Ausführungsform umfasst wenigstens eine Metallisierungsschicht eines Bauelements, insbesondere eines DCB-Substrats, eine Lage aus Kupfer, auf der eine Lage aus Nickel aufgebracht ist. Gegebenenfalls kann auf der Lage aus Nickel nochmals eine Lage aus Gold aufgebracht sein. Die Dicke der Lage aus Nickel beträgt in diesem Fall vorzugsweise 1 - 2 µm und die Dicke der Lage aus Gold vorzugsweise 0,05 - 0,3 µm. Andererseits kann es auch bevorzugt sein, wenn eine Metallisierungsschicht eines Bauelements eine Lage aus Silber oder Gold und darüber eine Lage aus Palladium oder Platin umfasst.

Gemäß einer weiteren bevorzugten Ausführungsform enthalten die einzelnen Lagen neben den genannten reinen Metallen oder Legierungen auch ein Glas. Es kann auch bevorzugt sein, wenn die Lagen eine Mischung aus (i) Glas und (ii) den reinen Metallen oder Legierungen darstellen.

Erfindungsgemäß werden wenigstens zwei Bauelemente durch Sintern miteinander verbunden.

Dazu werden zunächst die wenigstens zwei Bauelemente miteinander in Kontakt gebracht. Das Kontaktieren erfolgt dabei über die erfindungsgemäße Metallpaste. Zu diesem Zweck wird eine Anordnung bereitgestellt, bei der sich zwischen jeweils zwei der wenigstens zwei Bauelemente Metallpaste befindet.

Sollen daher zwei Bauelemente, Bauelement 1 und Bauelement 2, miteinander verbunden werden, so befindet sich die erfindungsgemäße Metallpaste vor dem Sintern zwischen Bauelement 1 und Bauelement 2. Andererseits ist es denkbar, dass mehr als zwei Bauelemente miteinander verbunden werden. Beispielsweise können drei Bauelemente, Bauelement 1, Bauelement 2 und Bauelement 3, auf eine Weise miteinander verbunden werden, dass Bauelement 2 zwischen Bauelement 1 und Bauelement 3 liegt. In diesem Fall befindet sich die erfindungsgemäße Metallpaste sowohl zwischen Bauelement 1 und Bauelement 2 als auch zwischen Bauelement 2 und Bauelement 3.

Erfindungsgemäß vorgesehen ist, dass die einzelnen Bauelemente in einer Sandwichanordnung vorliegen und miteinander verbunden werden.

Unter Sandwichanordnung ist erfindungsgemäß eine Anordnung zu verstehen, bei der sich zwei Bauelemente übereinander befinden und die Bauelemente im Wesentlichen parallel zueinander sind.

Die Anordnung aus wenigstens zwei Bauelementen und Metallpaste, wobei sich Metallpaste zwischen zwei Bauelementen dieser Anordnung befindet, kann nach einem aus dem Stand der Technik bekannten Verfahren hergestellt werden.

Vorzugsweise wird zunächst wenigstens eine Oberfläche eines Bauelements 1 mit der erfindungsgemäßen Metallpaste versehen. Anschließend wird ein anderes Bauelement 2 mit einer seiner Oberflächen auf die Metallpaste, die auf die Oberfläche des Bauelements 1 aufgetragen worden ist, aufgesetzt.

Die Auftragung der Metallpaste auf die Oberfläche eines Bauelements kann mittels herkömmlicher Verfahren erfolgen. Vorzugsweise erfolgt die Auftragung der Metallpaste mittels Druckverfahren, so zum Beispiel mittels Siebdruck oder Schablonendruck. Andererseits kann die Auftragung der Metallpaste auch mittels Dispenstechnik, mittels Spraytechnik, mittels Pintransfer oder durch Dippen erfolgen.

Im Anschluss an die Auftragung der Metallpaste wird vorzugsweise die mit der Metallpaste versehene Oberfläche dieses Bauelements mit einer Oberfläche des damit zu verbindenden Bauelements über die Metallpaste in Kontakt gebracht. Somit befindet sich zwischen den zu verbindenden Bauelementen eine Schicht Metallpaste.

Die Nassschichtdicke zwischen den zu verbindenden Bauelementen liegt vorzugsweise im Bereich von 20 - 200 µm. Unter Nassschichtdicke wird erfindungsgemäß der Abstand zwischen den sich gegenüberliegenden Oberflächen der zu verbindenden Bauelemente vor dem Sinterprozess verstanden. Die bevorzugte Nasssichtdicke ist abhängig vom gewählten Verfahren zum Auftragen der Metallpaste. Wird die Metallpaste beispielsweise mittels Siebdruckverfahren aufgetragen, dann kann eine Nassschichtdicke von 20 - 50 µm bevorzugt sein. Erfolgt die Auftragung der Metallpaste mittels Schablonendruck, dann kann die bevorzugte Nassschichtdicke im Bereich von 50 - 200 µm liegen.

Gemäß einer bevorzugten Ausführungsform wird vor dem Sinterprozess ein Trocknungsschritt durchgeführt.

Unter Trocknung wird vorzugsweise eine Verringerung des Anteils des Lösungsmittels in der Metallpaste verstanden.

Gemäß einer bevorzugten Ausführungsform liegt der Anteil des Lösungsmittels in der Metallpaste nach der Trocknung im Bereich von 1-5 Gewichtsprozent, bezogen auf das Gewicht der getrockneten Metallpaste.
Die Trocknung kann einerseits nach der Herstellung der Anordnung, also nach der Kontaktierung der zu verbindenden Bauelemente erfolgen. Andererseits kann die Trocknung aber auch unmittelbar nach dem Auftragen der Metallpaste auf die wenigstens eine Oberfläche des Bauelements und vor der Kontaktierung mit dem zu verbindenden Bauelement erfolgen.

Die Trocknungstemperatur liegt vorzugsweise im Bereich von 50 -100°C.

Es versteht sich, dass die Trocknungszeit abhängig ist von der jeweiligen Zusammensetzung der Metallpaste und der Größe der zu sinternden Anordnung. Übliche Trocknungszeiten liegen im Bereich von 5-45 Minuten.

Die Anordnung aus den wenigstens zwei Bauelementen und zwischen den Bauelementen befindlicher Metallpaste wird schließlich erfindungsgemäß einem Sinterprozess unterzogen.

Bei diesem Sinterprozess handelt es sich um einen Niedertemperatursinterprozess.

Unter Niedertemperatursinterprozess ist erfindungsgemäß ein Sinterprozess zu verstehen, der vorzugsweise bei einer Temperatur von unter 200°C abläuft.

Der Prozessdruck liegt dabei vorzugsweise unter 30 MPa, mehr bevorzugt unter 5 MPa und noch mehr bevorzugt unter 1 MPa. Aufgrund der Verwendung der erfindungsgemäßen Metallpaste gelingt das Sintern sogar ohne jegliche Anwendung von Prozessdruck, also bei einem Prozessdruck von 0 MPa.

Die Sinterzeit ist abhängig vom Prozessdruck und liegt vorzugsweise im Bereich von 2-45 Minuten.

Erfindungsgemäß kann der Sinterprozess in einer Atmosphäre erfolgen, die nicht weiter eingeschränkt ist. Vorzugsweise wird das Sintern jedoch in einer Atmosphäre durchgeführt, die Sauerstoff enthält.

Das Sintern wird in einer herkömmlichen, zum Sintern geeigneten Vorrichtung durchgeführt, in der sich vorzugsweise die vorstehend beschriebenen Prozessparameter einstellen lassen.

Die Erfindung wird im Folgenden anhand der nachstehend aufgeführten Beispiele erläutert, die jedoch nicht als einschränkend verstanden werden sollen.

### Beispiele:

### 1. Herstellung von Metallpasten:

Zunächst wurden die erfindungsgemäßen Metallpasten 1-7 und die Vergleichspasten 1 und 2 durch Vermischen der einzelnen Bestandteile hergestellt.

### 1.1 Erfindungsgemäße Metallpaste 1:

Es wurde eine Metallpaste hergestellt, die 81,5 Gewichtsprozent gecoatete Silberpartikel mit einem mittleren Teilchendurchmesser von 1 - 5 µm (Coatingmenge: < 2 Gewichtsprozent Natriumstearat), 5 Gewichtsprozent Silbercarbonat, 6 Gewichtsprozent Terpineol, 4 Gewichtsprozent 1-Dodecanol und 3,5 Gewichtsprozent Aluminiumformiat enthielt.

### 1.2 Erfindungsgemäße Metallpaste 2:

Es wurde eine Metallpaste hergestellt, die 79,5 Gewichtsprozent gecoatete Silberpartikel mit einem mittleren Teilchendurchmesser von 0,5 - 3 µm (Coatingmenge: < 2 Gewichtsprozent Natriumstearat), 3 Gewichtsprozent Silberoxid, 10,5 Gewichtsprozent Terpineol und 7 Gewichtsprozent Aluminiumformiat enthielt.

### 1.3 Erfindungsgemäße Metallpaste 3:

Es wurde eine Metallpaste hergestellt, die 80,5 Gewichtsprozent gecoatete Silberpartikel mit einem mittleren Teilchendurchmesser von 2 -15 µm (Coatingmenge: < 2 Gewichtsprozent Natriumstearat), 3,5 Gewichtsprozent Silbercarbonat, 5 Gewichtsprozent Kupfer(II)-formiat, 6 Gewichtsprozent Terpineol und 5 Gewichtsprozent 1-Hexanol enthielt.

### 1.4 Erfindungsgemäße Metallpaste 4:

Es wurde eine Metallpaste hergestellt, die 81 Gewichtsprozent gecoatete Silberpartikel mit einem mittleren Teilchendurchmesser von 0,5 - 5 µm (Coatingmenge: < 2 Gewichtsprozent Natriumstearat), 4,3 Gewichtsprozent Silberoxid, 3,5 Gewichtsprozent Mangan(III)-formiat, 6 Gewichtsprozent 1-Hexanol und 5,2 Gewichtsprozent 1-Dodecanol enthielt.

### 1.5 Erfindungsgemäße Metallpaste 5

Es wurde eine Metallpaste hergestellt, die 76,4 Gewichtsprozent gecoatete Silberpartikel mit einem mittleren Teilchendurchmesser von 0,5 - 5 µm (Coatingmenge: < 2 Gewichtsprozent Natriumstearat), 4,3 Gewichtsprozent Silberoxid, 2 Gewichtsprozent Silbercarbonat, 6 Gewichtsprozent Aluminiumformiat, 6,3 Gewichtsprozent Tridecanol und 5 Gewichtsprozent 1-Isotridecanol enthielt.

### 1.6 Erfindungsgemäße Metallpaste 6

Es wurde eine Metallpaste hergestellt, die 76,4 Gewichtsprozent gecoatete Silberpartikel mit einem mittleren Teilchendurchmesser von 0,5 - 5 µm (Coatingmenge: < 2 Gewichtsprozent Natriumstearat), 4,3 Gewichtsprozent Silberoxid, 2 Gewichtsprozent Silbercarbonat, 4 Gewichtsprozent Aluminiumformiat, 2 Gewichtsprozent Kupfer(II)-formiat, 6,3 Gewichtsprozent Tridecanol und 5 Gewichtsprozent 1-Isotridecanol enthielt.

### 1.7 Erfindungsgemäße Metallpaste 7:

Es wurde eine Metallpaste hergestellt, die 79,7 Gewichtsprozent gecoatete Silberpartikel mit einem mittleren Teilchendurchmesser von 0,5 - 5 µm (Coatingmenge: < 2 Gewichtsprozent Natriumstearat), 2 Gewichtsprozent Silbercarbonat, 4 Gewichtsprozent Aluminiumformiat, 2 Gewichtsprozent Kupfer(II)-formiat, 6,3 Gewichtsprozent Tridecanol und 6 Gewichtsprozent Terpineol enthielt.

### 1.8 Vergleichspaste 1:

Es wurde eine Metallpaste hergestellt, die 79,5 Gewichtsprozent gecoatete Silberpartikel mit einem mittleren Teilchendurchmesser von 0,5 - 3 µm (Coatingmenge: < 2 Gewichtsprozent Natriumstearat), 3 Gewichtsprozent Silberoxid, 10,5 Gewichtsprozent Terpineol und 7 Gewichtsprozent Ameisensäure enthielt. Die Vergleichspaste 1 entspricht somit der erfindungsgemäßen Metallpaste 2 mit der Abweichung, dass das Aluminiumsalz der Ameisensäure, Aluminiumformiat, durch Ameisensäure ersetzt ist.

### 1.9 Vergleichspaste 2:

Es wurde eine Metallpaste hergestellt, die 83 Gewichtsprozent gecoatete Silberpartikel mit einem mittleren Teilchendurchmesser von 0,5 - 3 µm (Coatingmenge: < 2 Gewichtsprozent Natriumstearat), 6,5 Gewichtsprozent Silberoxid, 10,5 Gewichtsprozent Terpineol und 7 Gewichtsprozent Ameisensäure enthielt. Die Vergleichspaste 2 entspricht somit der erfindungsgemäßen Metallpaste 2 mit der Abweichung, dass kein Aluminiumformiat enthalten, sondern stattdessen der Anteil an Silberpartikeln und Silberoxid erhöht ist.

### 2. Ausführungsbeispiele:

Die hergestellten Metallpasten wurden zum Sintern von zwei miteinander zu verbindenden Bauelementen verwendet.

### 2.1 Ausführungsbeispiel 1:

In diesem Beispiel wurden DCB-Substrate, die jeweils eine Metallisierungsschicht aus Silber aufwiesen, und IGBTs, die ebenfalls jeweils eine Metallisierungsschicht aus Silber enthielten, durch Sintern miteinander verbunden.

Dazu wurden auf die Metallisierungsschicht der einzelnen DCB-Substrate die erfindungsgemäßen Metallpasten 1-7 bzw. die Vergleichspasten 1 und 2 mittels Siebdruckverfahren aufgebracht. Im Anschluss daran wurden die einzelnen IGBTs mit der Metallisierungsschicht auf die Pasten gesetzt.

In den Fällen, in denen die erfindungsgemäßen Metallpasten 1 und 4-6 eingesetzt wurden, erfolgte eine Trocknung des Aufbaus aus DCB-Substrat, Metallpaste und IGBT bei 80°C für 20 Minuten. In den anderen Fällen war eine Trocknung nicht erforderlich. Die Nassschichtdicke betrug jeweils 100 µm.

Der so hergestellte Aufbau wurde für 20 Sekunden bei einem Prozessdruck von 5 MPa und unterschiedlichen Prozesstemperaturen gesintert.

### 2.2 Ausführungsbeispiel 2:

Dieses Ausführungsbeispiel entspricht Ausführungsbeispiel 1 mit der Abweichung, dass der erhaltene Aufbau für 15 Minuten druckfrei gesintert wurde.

### 2.3 Ausführungsbeispiel 3:

In diesem Beispiel wurden Leadframes, die jeweils eine Metallisierungsschicht aufwiesen, die aus einer Lage Nickel und einer Lage Gold bestanden, wobei sich an der Außenseite die Goldlage befand, und Dioden, die jeweils eine Metallisierungsschicht aus Silber enthielten, durch Sintern miteinander verbunden.

Dazu wurden auf die Metallisierungsschicht der einzelnen Leadframes die erfindungsgemäßen Metallpasten 1-7 bzw. die Vergleichspasten 1 und 2 mittels Schablonendruckverfahren aufgebracht. Im Anschluss daran wurden die einzelnen Dioden mit der Metallisierungsschicht auf die Pasten gesetzt.

In den Fällen, in denen die erfindungsgemäßen Metallpasten 1 und 4-6 eingesetzt wurden, erfolgte eine Trocknung des Aufbaus aus DCB-Substrat, Metallpaste und IGBT bei 80°C für 20 Minuten. In den anderen Fällen war eine Trocknung nicht erforderlich. Die Nassschichtdicke betrug jeweils 100 µm.

Der so hergestellte Aufbau wurde für 20 Sekunden bei einem Prozessdruck von 5 MPa und unterschiedlichen Prozesstemperaturen gesintert.

### 2.4 Ausführungsbeispiel 4:

Dieses Ausführungsbeispiel entspricht Ausführungsbeispiel 3 mit der mit der Abweichung, dass der erhaltene Aufbau für 15 Minuten druckfrei gesintert wurde.

### 3 Ergebnisse:

### 3.1 Ausführungsbeispiele 1 und 3:

In den Ausführungsbeispielen, in denen die erfindungsgemäßen Metallpasten 1-7 verwendet wurden, betrug die Sintertemperatur jeweils etwa 195°C. Dagegen betrug die Sintertemperatur in den Ausführungsbeispielen, in denen die Vergleichspasten 1 und 2 verwendet wurden, jeweils etwa 230°C.

### 3.2 Ausführungsbeispiele 2 und 4:

In den Ausführungsbeispielen, in denen die erfindungsgemäßen Metallpasten 1-7 verwendet wurden, betrug die Sintertemperatur jeweils etwa 185°C. Dagegen betrug die Sintertemperatur in den Ausführungsbeispielen, in denen die Vergleichspasten 1 und 2 verwendet wurden, jeweils etwa 230°C.

## Patentansprüche

1. Metallpaste enthaltend
(A) 75 - 90 Gewichtsprozent wenigstens eines Metalls, das in Form von Partikeln vorliegt, die ein Coating aufweisen, das wenigstens eine organische Verbindung enthält,
(B) 0,1 - 12 Gewichtsprozent wenigstens eines Metallprecursors,
(C) 6 - 20 Gewichtsprozent wenigstens eines Lösungsmittels und
(D) 0,1 - 15 Gewichtsprozent wenigstens eines während eines Sinterprozesses Kohlenmonoxid freisetzenden Sinterhilfsmittels, das aus der Gruppe ausgewählt ist, bestehend aus
(i) Salzen von organischen Säuren, wobei die organischen Säuren 1 - 4 Kohlenstoffatome aufweisen,
(ii) Estern von organischen Säuren, wobei die organischen Säuren 1 - 4 Kohlenstoffatome aufweisen, und
(iii) Carbonylkomplexen.

2. Metallpaste nach Anspruch 1, **dadurch gekennzeichnet, dass** die Salze aus der Gruppe ausgewählt sind, die aus Acetaten, Carbonaten, Formiaten, Lactaten und Oxalaten besteht.

3. Metallpaste nach Anspruch 2, **dadurch gekennzeichnet, dass** die Salze aus der Gruppe ausgewählt sind, die aus Kupfer(II)-acetat, Eisen(II)-acetat und Zinn(II)-acetat besteht.

4. Metallpaste nach Anspruch 2, **dadurch gekennzeichnet, dass** die Salze aus der Gruppe ausgewählt sind, die aus Eisen(II)-carbonat und Kupfer(II)-carbonat besteht.

5. Metallpaste nach Anspruch 2, **dadurch gekennzeichnet, dass** die Salze aus der Gruppe ausgewählt sind, die aus Magnesiumformiat, Aluminiumformiat, Eisen(II)-formiat, Zinn(II)-formiat, Kupfer(II)-formiat, Silber(II)-formiat und Mangan(III)-formiat besteht.

6. Metallpaste nach Anspruch 2, **dadurch gekennzeichnet, dass** die Salze aus der Gruppe ausgewählt sind, die aus Kupfer(II)-lactat und Silber(I)-lactat besteht.

7. Metallpaste nach Anspruch 2, **dadurch gekennzeichnet, dass** das Salz aus der Gruppe ausgewählt ist, die aus Eisen(II)-oxalat, Eisen(III)-oxalat und Kobalt(II)-oxalat besteht.

8. Metallpaste nach Anspruch 1, **dadurch gekennzeichnet, dass** die Ester aus der Gruppe ausgewählt sind, die aus Methylformiat, Ethylformiat, Propylformiat und Butylformiat besteht.

9. Metallpaste nach Anspruch 1, **dadurch gekennzeichnet, dass** die Carbonylkomplexe aus der Gruppe ausgewählt sind, die aus Metallcarbonylen besteht.

10. Metallpaste nach Anspruch 9, **dadurch gekennzeichnet, dass** das Metallcarbonyl ein Eisencarbonyl ist.

11. Metallpaste nach Anspruch 1, **dadurch gekennzeichnet, dass** die wenigstens eine organische Verbindung aus der Gruppe ausgewählt ist, die aus freien Fettsäuren, Fettsäuresalzen und Fettsäureestern, die jeweils 8 - 24 Kohlenstoffatome aufweisen, besteht.

12. Metallpaste nach einem der Ansprüche 1 - 11, **dadurch gekennzeichnet, dass** das molare Verhältnis von Sinterhilfsmitteln zu den im Coating enthaltenen organischen Verbindungen im Bereich von 1 : 1 bis 150 : 1 liegt.

13. Verfahren zum Verbinden wenigstens zweier Bauelemente, bei dem man
(a) eine Sandwichanordnung bereitstellt, die wenigstens
(a1) ein Bauelement 1,
(a2) ein Bauelement 2 und
(a3) eine Metallpaste aufweist, die sich zwischen Bauelement 1 und Bauelement 2 befindet, und
(b) die Sandwichanordnung sintert,
**dadurch gekennzeichnet, dass** die Metallpaste
(A) 75 - 90 Gewichtsprozent wenigstens eines Metalls, das in Form von Partikeln vorliegt, die ein Coating aufweisen, das wenigstens eine organische Verbindung enthält
(B) 0,1 - 12 Gewichtsprozent wenigstens eines Metallprecursors,
(C) 6 - 20 Gewichtsprozent wenigstens eines Lösungsmittels und
(D) 0,1 - 15 Gewichtsprozent wenigstens eines während eines Sinterprozesses Kohlenmonoxid freisetzenden Sinterhilfsmittels, das aus der Gruppe ausgewählt ist, bestehend aus
(i) Salzen von organischen Säuren, wobei die organischen Säuren 1 - 4 Kohlenstoffatome aufweisen,
(ii) Estern von organischen Säuren, wobei die organischen Säuren 1 - 4 Kohlenstoffatome aufweisen, und
(iii) Carbonylkomplexen,
umfasst.

14. Verfahren nach Anspruch 13, **dadurch gekennzeichnet, dass** das Sintern bei einer Temperatur von weniger als 200°C stattfindet.

## Claims

1. Metal paste containing
(A) 75 - 90 % by weight of at least one metal that is present in the form of particles comprising a coating containing at least one organic compound;
(B) 0.1 - 12 % by weight of at least one metal precursor;
(C) 6 - 20 % by weight of at least one solvent; and
(D) 0.1 - 15 % by weight of at least one sintering aid that releases carbon monoxide during the sintering process selected from the group consisting of
(i) salts of organic acids, whereby the organic acids comprise 1 - 4 carbon atoms;
(i) esters of organic acids, whereby the organic acids comprise 1 - 4 carbon atoms; and
(iii) carbonyl complexes.

2. Metal paste according to claim 1, **characterised in that** the salts are selected from the group consisting of acetates, carbonates, formates, lactates and oxalates.

3. Metal paste according to claim 2, **characterised in that** the salts are selected from the group consisting of copper(II) acetate, iron(II) acetate and tin(II) acetate.

4. Metal paste according to claim 2, **characterised in that** the salts are selected from the group consisting of iron(II) carbonate and copper(II) carbonate.

5. Metal paste according to claim 2, **characterised in that** the salts are selected from the group consisting of magnesium formate, aluminium formate, iron(II) formate, tin(II) formate, copper(II) formate, silver(II) formate and manganese(III) formate.

6. Metal paste according to claim 2, **characterised in that** the salts are selected from the group consisting of copper(II) lactate and silver(II) lactate.

7. Metal paste according to claim 2, **characterised in that** the salt is selected from the group consisting of iron(II) oxalate, iron(III) oxalate and cobalt(II) oxalate.

8. Metal paste according to claim 1, **characterised in that** the esters are selected from the group consisting of methylformate, ethylformate, propylformate and butylformate.

9. Metal paste according to claim 1, **characterised in that** the carbonyl complexes are selected from the group consisting of methylcarbonyls.

10. Metal paste according to claim 9, **characterised in that** the metal carbonyl is an iron carbonyl.

11. Metal paste according to claim 1, **characterised in that** the at least one organic compound is selected from the group consisting of free fatty acids, fatty acid salts and fatty acid esters which each comprise 8 - 24 carbon atoms.

12. Metal paste according to any one of the claims 1 - 11, **characterised in that** the molar ratio of sintering aids to the organic compounds contained in the coating is in the range of 1 : 1 to 150 : 1.

13. Method for connecting at least two components comprising
(a) providing a sandwich arrangement that comprises at least
(a1) one component 1;
(a2) one component 2; and
(a3) one metal paste that is situated between component 1 and component 2; and
(b) sintering the sandwich arrangement;
**characterised in that** the metal paste comprises
(A) 75 - 90 % by weight of at least one metal that is present in the form of particles comprising a coating containing at least one organic compound
(B) 0.1 - 12 % by weight of at least one metal precursor;
(C) 6 - 20 % by weight of at least one solvent; and
(D) 0.1 - 15 % by weight of at least one sintering aid that releases carbon monoxide during the sintering process selected from the group consisting of
(i) salts of organic acids, whereby the organic acids comprise 1 - 4 carbon atoms;
(i) esters of organic acids, whereby the organic acids comprise 1 - 4 carbon atoms; and
(iii) carbonyl complexes.

14. Method according to claim 13, **characterised in that** the sintering proceeds at a temperature below 200°C.

## Revendications

1. Pâte métallique comprenant
(A) 75 - 90 pourcents en poids d'au moins un métal qui est présent sous forme de particules qui présentent un enrobage qui contient au moins une liaison organique,
(B) 0,1-12 pourcents en poids d'au moins un précurseur métallique,
(C) 6 - 20 pourcents en poids d'au moins un solvant et
(D) 0,1 - 15 pourcents en poids d'au moins un auxiliaire de frittage qui libèrent du monoxyde de carbone pendant le processus de frittage sélectionné parmi le groupe composé
(i) de sels d'acides organiques, sachant que les acides organiques présentent 1 - 4 atomes de carbone,
(ii) d'esters d'acides organiques, sachant que les acides organiques présentent 1 - 4 atomes de carbone, et
(iii) de complexes de carbonyle.

2. Pâte métallique selon la revendication 1, **caractérisée en ce que** les sels sont sélectionnés parmi le groupe composé des acétates, des carbonates, des formates, des lactates et des oxalates.

3. Pâte métallique selon la revendication 2, **caractérisée en ce que** les sels sont sélectionnés parmi le groupe composé d'acétate de cuivre(II), d'acétate de fer(II) et d'acétate d'étain(II).

4. Pâte métallique selon la revendication 2, **caractérisée en ce que** les sels sont sélectionnés parmi le groupe composé de carbonate de fer(II) et de carbonate de cuivre(II).

5. Pâte métallique selon la revendication 2, **caractérisée en ce que** les sels sont sélectionnés parmi le groupe composé de formate de magnésium, formate d'aluminium, formate de fer(II), formate d'étain(II), formate de cuivre(II), formate d'argent(II) et formate de manganèse(III).

6. Pâte métallique selon la revendication 2, **caractérisée en ce que** les sels sont sélectionnés parmi le groupe composé de lactate de cuivre(II) et de lactate d'argent (I).

7. Pâte métallique selon la revendication 2, **caractérisée en ce que** le sel est sélectionné parmi le groupe composé d'oxalate de fer(II), d'oxalate de fer(III) et d'oxalate de cobalt(II).

8. Pâte métallique selon la revendication 1, **caractérisée en ce que** les sels sont sélectionnés parmi le groupe composé de formate de méthyle, formate d'éthyle, formate de propyle et formate de butyle.

9. Pâte métallique selon la revendication 1, **caractérisée en ce que** les complexes de carbonyle sont sélectionnés parmi le groupe composé de carbonyles métalliques.

10. Pâte métallique selon la revendication 9, **caractérisée en ce que** le carbonyle métallique est un carbonyle de fer.

11. Pâte métallique selon la revendication 1, **caractérisée en ce que** l'au moins une liaison organique est sélectionnée parmi le groupe composé des acides gras libres, des sels d'acide gras et des esters d'acide gras qui présentent respectivement 8- 24 atomes de carbone.

12. Pâte métallique selon l'une des revendications 1 - 11, **caractérisée en ce que** le rapport molaire des auxiliaires de frittage avec les liaisons organiques contenues dans l'enrobage, est situé dans la plage de 1 : 1 à 150 : 1.

13. Procédé de liaison d'au moins deux constituants, dans lequel
(a) un agencement en sandwich est préparé, lequel présente au moins
(a1) un constituant 1,
(a2) un constituant 2 et
(a3) une pâte métallique qui se trouve entre le constituant 1 et le constituant 2, et
(b) fritte l'agencement en sandwich,
**caractérisé en ce que** la pâte métallique
(A) contient 75 - 90 pourcents en poids d'au moins un métal présent sous forme de particules qui présentent un enrobage qui contient au moins une liaison organique
(B) 0,1 - 12 pourcents en poids d'au moins un précurseur métallique,
(C) 6 - 20 pourcents en poids d'au moins un solvant et
(D) 0,1 - 15 pourcents en poids d'au moins un auxiliaire de frittage qui libèrent du monoxyde de carbone pendant le processus de frittage sélectionné parmi le groupe composé
(i) de sels d'acides organiques, sachant que les acides organiques présentent 1 - 4 atomes de carbone,
(ii) d'esters d'acides organiques, sachant que les acides organiques présentent 1 - 4 atomes de carbone, et
(iii) de complexes de carbonyle.

14. Procédé selon la revendication 13, **caractérisé en ce que** le frittage est effectué à une température inférieure à 200°C.
